# EUROPEAN PATENT APPLICATION

(11) **EP 2 242 256 A1**
(43) Date of publication of application: **20.10.2010**
(21) Application number: 09707681.4
(22) Date of filing: 04.02.2009
(51) Int. Cl.: H04N 5/335, H01L 23/29, H01L 27/14

(54) **SOLID-STATE IMAGING DEVICE AND METHOD FOR MANUFACTURING THE SAME**

(30) Priority: 06.02.2008 JP 2008026278
(71) Applicant: Panasonic Corporation, Kadoma-shi Osaka 571-8501 (JP)
(72) Inventor: TAKESWHITA, Takao, Osaka-shi Osaka 540-6207 (JP); NAKAGIRI, Yasushi, Osaka-shi Osaka 540-6207 (JP)
(74) Representative: Grünecker, Kinkeldey, Stockmair & Schwanhäusser Anwaltssozietät
(86) International application number: PCT/JP2009/000435
(87) International publication number: WO 2009/098875

(57) **Abstract**

In association with an improvement in functions of a solid state imaging device, heat generated by a solid state imaging element board becomes greater, which raises a problem of occurrence of a signal error operation.

In the solid state imaging device of the present invention, a rear surface of a solid state imaging element board is molded with a resin. The mold resin has an uneven shape, whereby a radiating area is increased, a temperature rise due to generation of heat in the solid state imaging element board is prevented, and occurrence of error operation can be prevented.

## Description

### Technical Field

The present invention relates to a solid state imaging device and a manufacturing method thereof, and more particularly to a small solid state imaging device using a solid state imaging element, such as a monitoring camera, a medical camera, a vehicle-mounted camera, and a camera for use in an information communication terminal and to a method for manufacturing the solid state imaging device.

### Background Art

In recent years, there is rapidly developed a demand for a small camera for a portable phone, a vehicle-mounted component, etc. This type of small camera uses a solid state imaging device that outputs an image as an electric signal by a solid state imaging element, the image being input through an optical system such as a lens. Cameras become smaller as the imaging device becomes further miniaturized and sophisticated. As a result, use of the cameras in various quarters is increased, and a market for the cameras serving as video input devices is now expanding. In an imaging device using a related-art semiconductor imaging element, each of components such as a lens, a semiconductor imaging element, and an LSI equipped with a drive circuit and a signal processing circuit for the semiconductor imaging element, are formed on casings or structures, and the components are combined. A mounting structure implemented by such a combination is made by mounting elements on a flat-plate-shaped printed board. However, because of a demand for a further reduction in thickness of a portable phone, or the like, a demand for slimming down individual devices is growing year by year. In order to meet the demand, an attempt is made to further slim down the imaging device by use of a flexible wiring board or by mounting an IC directly on a light-transmitting member though a flip-chip mounting process.

For example, Patent Document 1 discloses a structure in which a light-transmitting member and a photoelectric conversion element are disposed opposite each other across a flexible wiring board.
Fig. 8 shows the photoelectric conversion element described in connection with Patent Document 1. In the conversion element, a light-transmitting member 101 is bonded to a flexible wiring board 102 via an adhesive 103. In the flexible wiring board 102, a metal wiring pattern 105 is laid on a resin film 104, and an opening 106 is formed therein. The light-transmitting member 101 and an imaging element 112 are disposed opposite each other across the opening 106. Bumps 113 are provided on an electrode pad 117 of the solid state imaging element 112 including microlenses 115 formed in an imaging area of the imaging element 112. The bumps 113 are electrically connected to the metal wiring pattern 105 of the flexible board 102 via an anisotropic conductive film 111. Further, bonding strength of the solid state imaging element 112 is further reinforced by a sealing resin 116.

In the meantime, when the solid state imaging device is slimmed down and when the solid state imaging element having a large number of pixels is used as mentioned above, heat generated during operation of the solid state imaging element becomes greater, to thus make the IC hot. As a result, it becomes difficult to ignore resultant occurrence of faulty operation of a signal and the influence of a portable phone, or the like, equipped with a solid state imaging element becoming partially hot. Patent Document 2 discloses a method for dissipating heat of a solid state imaging device as countermeasures against the faulty operation and the influence.

In a solid state imaging device described in Patent Document 2, a Peltier element cools a heated solid state imaging element, and heat is dissipated through a heat sink disposed opposite to the solid state imaging element.

Patent Document 1: JP-B-3207319
Patent Document 2: JP-A-6-233311

### Disclosure of the Invention

### Problem to be Solved by the Invention

However, in the imaging device described in Patent Document 1, the light-transmitting member and the photoelectric conversion element are held only by the flexible wiring board. Hence, their rigidity cannot be maintained. When the imaging device is mounted in a device requiring high durability pertaining to impact and pressing such as a portable phone, there arises a problem of a failure to assure strength of the imaging element, which in turn causes a problem in electrical connection.

When the method described in Patent Document 2 is applied to the solid state imaging device, it is necessary to attach the Peltier element and to join the Peltier element to the casing by a meandering heat conduction member. Further, it is necessary to provide power wirings, etc., used for driving the Peltier element. Consequently, there is a problem of an increase in the size and the cost of the imaging device.

The present invention was made in view of the above-described circumstance, and an object thereof is to provide a slim, highly-reliable solid state imaging device capable of efficiently dissipating heat.

### Means for Solving the Problem

A solid state imaging device of the present invention is **characterized in that** a resin mold having a surface of an uneven shape is formed on a rear surface of a solid state imaging element flip-chip mounted to a substrate having an opening portion.
According to the configuration, since an area contacting air becomes greater, heat developing from the solid state imaging element can effectively be discharged, which can prevent error caused when the solid state imaging element is raised to high temperature. Since the solid state imaging device has a simple structure for dissipating heat from the rear surface of the solid state imaging element, the solid state imaging device can easily be slimmed down and have high rigidity. Consequently, it is possible to provide a superior solid state imaging device that enables a reduction of size of a portable phone, etc.

According to the present invention, in the solid state imaging device, the resin mold includes a portion where a distance between an outer surface and the solid state imaging element is large and a portion where the distance is small, thereby having a radiator fin function.
By the configuration, heat generated by the solid state imaging element transfers along an outer surface of the radiating fin, so that the heat is efficiently dissipated into outside air.

The present invention includes the solid state imaging device in which the uneven shape includes a strip pattern.
By the configuration, the heat of the solid state imaging element is efficiently dissipated into the outside air by the outside air forming a laminar flow by grooves of the strip pattern.

The present invention includes the solid state imaging device in which the uneven shape defines a plurality of pillar-shaped projections.
The configuration can increase the surface area of the outer surface of the resin mold, and also increase the area contacting the outside air, whereby heat of the solid state imaging element is efficiently dissipated into the outside air.

The present invention includes the solid state imaging device in which the uneven shape includes a lattice pattern.
The configuration can increase the surface area of the outer surface of the resin mold and also increase the area contacting the outside air becomes. Further, grooves penetrating into side surfaces are formed in the lattice pattern along an outer wall of the uneven surface formed in the lattice pattern. Consequently, a laminar flow is efficiently generated, and heat of the solid state imaging element is efficiently dissipated to the outside.

In the solid state imaging device, the present invention is characterized by comprising: a multilayer board including a flexible wiring board having an opening portion (hereinafter called a "flexible wiring board") and a reinforcing plate integrally stacked on the flexible wiring board; a light-transmitting member placed on a reinforcing plate side of the multilayer board so as to close the opening portion; and a solid state imaging element board placed on a flexible wiring board side of the multilayer board, wherein the reinforcing plate has a reference hole used for setting the solid state imaging element board, and wherein the reinforcing plate is exposed from the flexible wiring board around a peripheral edge of the reference hole, and the solid state imaging element board and the light-transmitting member are placed on both sides of the multilayer board while the reference hole is taken as a common reference.
According to the configuration, the solid state imaging device has advantages in which high rigidity can be provided even when having a small thickness, strength for the solid state imaging element can also be assured, and the optical axes can be aligned with high precision. Specifically, the flexible board and the reinforcing plate have the same outer shape and dimension and form a multilayer structure. The reinforcing plate has the reference hole used when the solid state imaging element board and the light-transmitting member (or an optical lens) are mounted. A surface of the reinforcing plate is exposed from the flexible wiring board side around the reference hole. The solid state imaging element board and the light-transmitting member can be placed by commonly using the reference hole from both front side and back side thereof. Therefore, the solid state imaging device can be easily slimmed down and assembled with superior operability. Further, it is possible to obtain high rigidity and high precision of alignment of optical axes. Consequently, a superior solid state imaging device exhibiting superiority in miniaturization, such as a portable phone, can be provided. As used herein, the term "solid state imaging element board" means a board produced by forming a solid state imaging element on a semiconductor board, such as a silicon board, principally, an individually divided chip. The reference hole may include a so-called cut portion partially communicating the outside, as well as a so-called positioning hole in which an outer edge thereof is surrounded by a wall. Further, a wiring pattern, an outer profile, etc., taking the reference hole as a reference may also be indirectly used for positioning.

The present invention includes the solid state imaging device in which the light-transmitting member and an optical lens are attached to the reinforcing plate, and the optical lens and the solid state imaging element board are positioned while the reference hole is taken as a common reference from both front side and back side thereof. Moreover, it is also preferable that the light-transmitting member is positioned while the reference hole is taken as a common reference.

The light-transmitting member used in the solid state imaging device of the present invention may be an optical filter. As a result, an infrared region of light entering the solid state imaging element is cut, so that a superior imaging characteristic can be acquired.

The reinforcing plate used in the solid state imaging device of the present invention may also be a metal plate. As a result, high rigidity for the solid state imaging device can be obtained.

A ground portion of a wiring pattern of the flexible wiring board used in the solid state imaging device of the present invention and the reinforcing plate made of a metal plate may be electrically connected together. Consequently, a stable electric characteristic can be yielded.

A periphery of the opening portion of the reinforcing plate where the light-transmitting member used in the solid state imaging device of the present invention is to be placed may be smaller in thickness than a surrounding of the opening portion. As a result, positional displacement of the light-transmitting member is eliminated, and spread of an adhesive for mounting purpose can also be suppressed.

There may be assured an electric path for extracting an electric signal from the flexible wiring board used in the solid state imaging device of the present invention by way of a connector or a wiring board. Consequently, the electric signal can be extracted while the flexible wiring board and the reinforcing plate are reduced to a minimum required size.

A chip component may be mounted on the flexible wiring board used in the solid state imaging device of the present invention. As a consequence, the degree of design freedom of electric wiring is increased, and chip components can be placed in the vicinity of the solid state imaging element, so that the electric characteristics can be optimized.

The present invention includes the solid state imaging device in which the resin mold is made of a high thermal conductive material.
The configuration enables efficient dissipation of heat of the solid state imaging element into the atmosphere.

The present invention includes: a step of mounting a solid state imaging element on a flexible wiring board having an opening portion though a flip-chip mounting process; a step of filling a rear surface of the solid state imaging element with molding resin; and a step of forming an uneven shape through a transfer using a stamper having a predetermined uneven shape after the step of filling, and hardening the resin with the uneven shape.

According to the configuration, it is possible to considerably easily form an uneven shape on the resin mold. Even when a shape or a material of the resin mold is changed for reasons of a change in model, such a change can readily be addressed. Therefore, it is possible to reduce cost without wasteful use of a resin.

The present invention also includes: a step of mounting a solid state imaging element on the flexible wiring board having an opening portion through a flip-chip mounting process; and a step of forming a resin sealed portion by injection molding using a metal mold having an uneven shape.
According to the configuration, it is possible to form an uneven shape with a higher degree of freedom than that provided by the stamper, so that heat radiation can be made more effective.

The present invention also includes: a step of mounting a solid state imaging element on a flexible wiring board having an opening portion through a flip-chip mounting process; and a step of forming a resin sealed portion by means of a hot melting technique using a metal molding having an uneven shape.
According to the configuration, it is possible to manufacture the solid state imaging device with a simpler facility and within a shorter period of time, so that manufacturing cost can be reduced.

### Advantages of the Invention

The present invention can slim down a solid state imaging device and can readily provide a highly reliable solid state imaging device exhibiting high rigidity and enhanced accuracy.
As a consequence, a portable terminal device can also be slimmed down.

### Brief Description of the Drawings

Fig. 1 is an exploded oblique perspective view of a solid state imaging device of a first embodiment of the present invention.
Fig. 2 is a top view of a flexible wiring board used in the solid state imaging device of the first embodiment.
Fig. 3 is an exploded oblique perspective view of the solid state imaging device of the first embodiment.
Fig. 4 is an oblique perspective view of the solid state imaging device of the first embodiment.
Fig. 5 is an oblique perspective view of the solid state imaging device of the first embodiment.
Fig. 6 is a view showing a result of simulation of a thermal fluid of the solid state imaging device of the first embodiment.
Fig. 7 is an oblique perspective view of a solid state imaging device of a second embodiment.

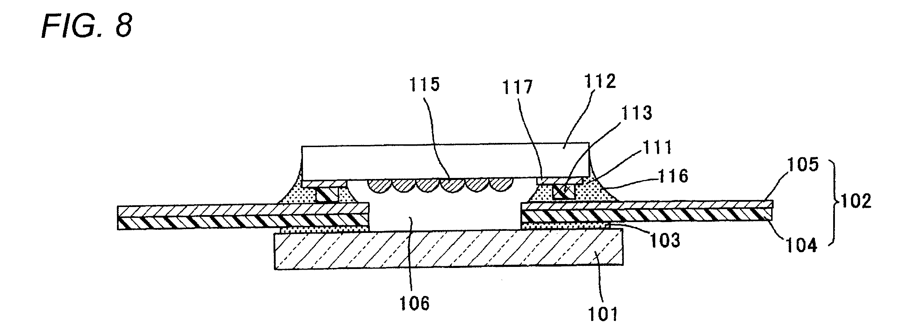

Fig. 8 is a cross sectional view of a related-art solid state imaging device.

### Description of Reference Signs

- 1: FLEXIBLE WIRING BOARD 1a FILM SUBSTRATE
- 1b: METAL WIRING PATTERN
- 2: REINFORCING PLATE
- 3: REFERENCE CUT PORTION
- 4, 6, 8: EXPOSED PORTION OF REINFORCING PLATE
- 5: REFERENCE HOLE
- 7: OPENING PORTION
- 10: SOLID STATE IMAGING ELEMENT BOARD
- 11: CHIP COMPONENT
- 12: CONNECTOR
- 13: STEP PORTION
- 14: LIGHT-TRANSMITTING MEMBER
- 15: OPTICAL LENS
- 16: LENS CASING
- 17: REFERENCE PROJECTING PORTION
- 18: MOLDING RESIN
- 19: MOLDING RESIN CUT PORTION
- 20: WIRING CABLE

### Best Mode for Carrying Out the invention

Embodiments of the present invention are described in detail hereunder by the drawings.

### (First Embodiment)

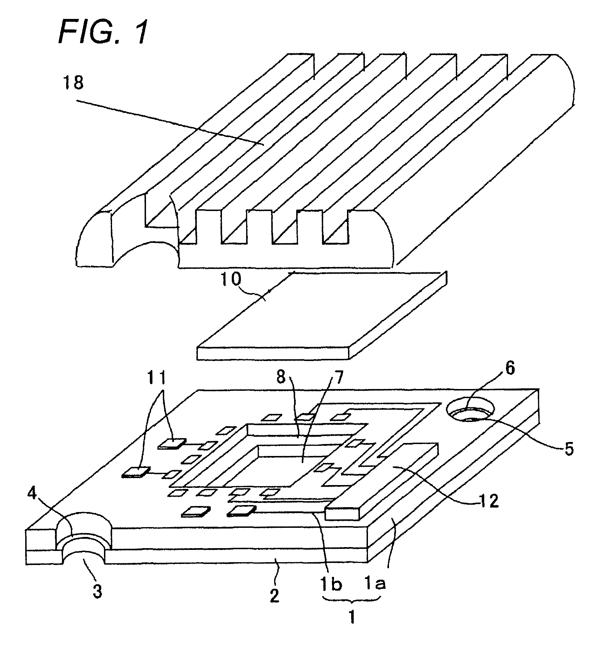

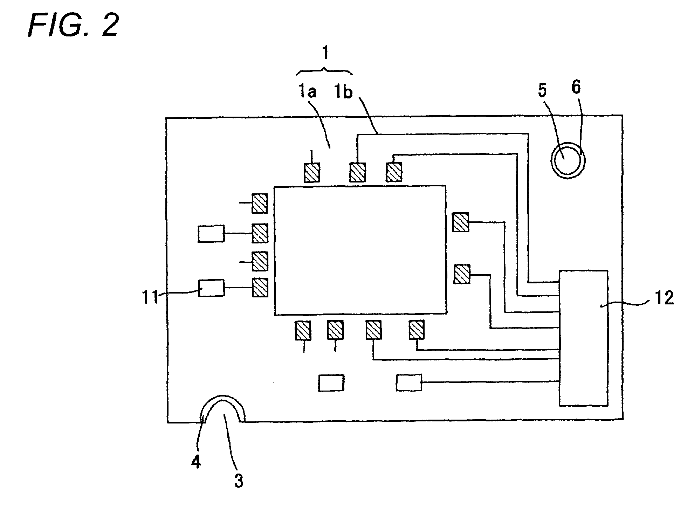

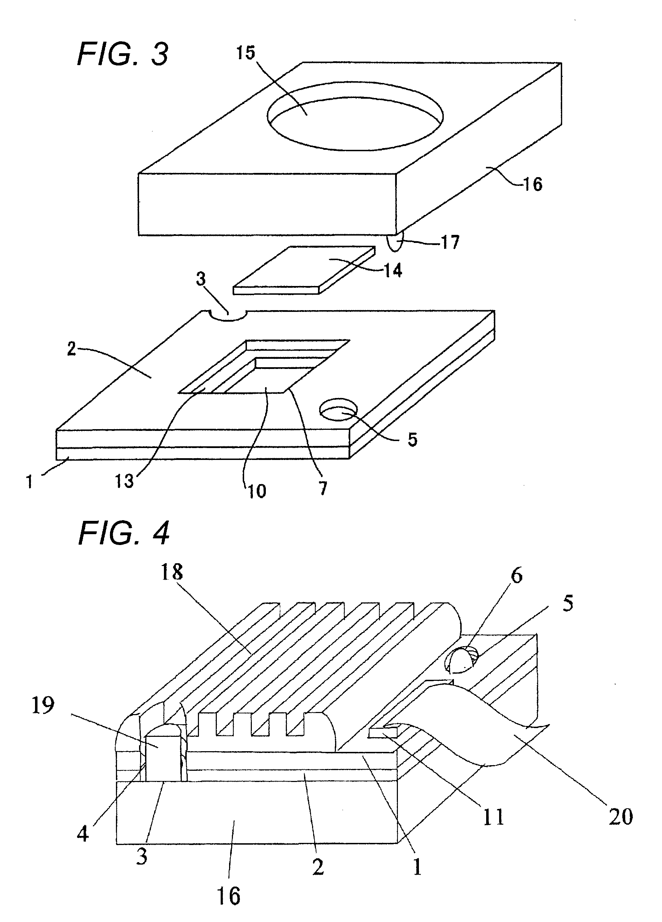

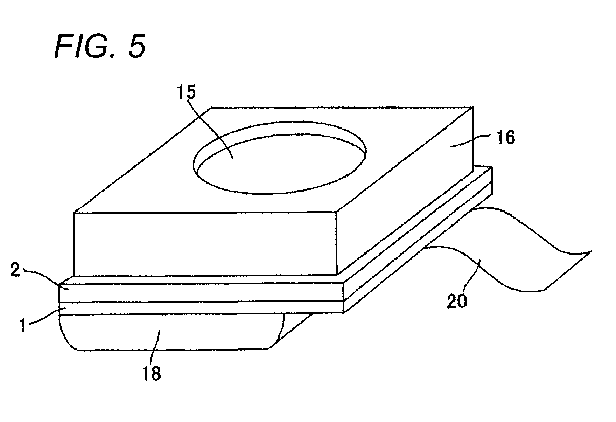

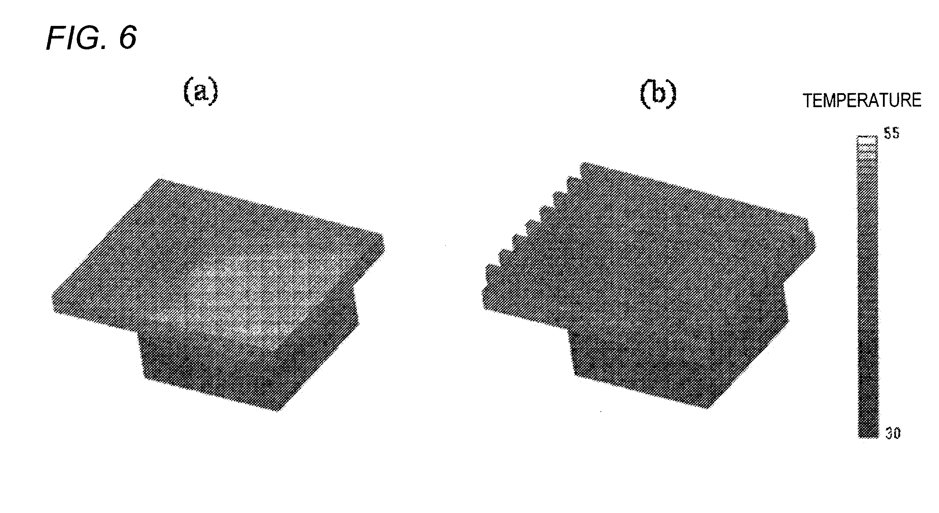

Fig. 1 is an exploded oblique perspective view of a solid state imaging device of a first embodiment. Fig. 2 is a top view of a flexible wiring board used in the solid state imaging device of the first embodiment. Fig. 3 is an exploded oblique perspective view of the solid state imaging device of the first embodiment acquired when viewed from behind. Fig. 4 is an oblique perspective view of the solid state imaging device of the present invention. Fig. 5 is an oblique perspective view of the solid state imaging device of the present invention. Further, Fig. 6 is a view showing a result of a radiation effect resultant from simulation of a thermal fluid.

As shown in Figs. 1 and 5, in the solid state imaging device, a resin mold 18 having a surface of an uneven shape is formed on a rear surface of a solid state imaging element board 10 which is mounted to the flexible wiring board 1 having an opening portion 7 through a flip-chip mounting process. The resin mold 18 can readily be made by, after coating a rear surface of the solid state imaging element with molding resin, forming the uneven shape at the coated rear surface by transfer using a stamper having an uneven, strip shape, and thereafter heating and hardening the resin.

The solid state imaging device includes: a multilayer board including the flexible wiring board 1 having the opening portion 7 and a reinforcing plate 2 on which the flexible wiring board 1 is integrally stacked; a light-transmitting member 14 and an optical lens 15 disposed on the reinforcing plate 2 side of the multilayer board so as to close the opening portion 7; and the solid state imaging element board 10 disposed on the flexible wiring board 1 side of the multilayer board. The reinforcing plate 2 includes a cut portion 3 and a positioning reference hole 5 that serve as reference holes for setting the solid state imaging element board. The reinforcing plate 2 is exposed to the flexible wiring board 1 around peripheral edges of the cut portion 3 and the positioning hole 5. While taking the two reference holes as common references, the solid state imaging element board, the light-transmitting member 14 and an optical lens 15 (a lens casing 16) are provided on both sides of the multilayer board.

In the embodiment, the flexible wiring board 1 and the reinforcing plate 2 having an outer shape and size identical with those of the flexible wiring board 1 are layered and bonded so as to be integrated together. In the flexible wiring board 1 employed in this case, a polyimide resin film having a thickness of 25 µm is used as a film substrate (a base film) 1 a, and a SUS plate having a thickness of 200 µm is used for the reinforcing plate 2. The cut portion 3 serving as the reference hole is opened in the reinforcing plate 2, and an exposed portion 4 of the reinforcing plate is formed around the cut portion 3. Further, the positioning hole 5 serving a reference hole is provided, and an exposed portion 6 of the reinforcing plate 2 is formed around the positioning hole 5. Specifically, the cut portion 3 and the positioning hole 5 that serve as the reference holes can be recognized from both front side and back side as reference shapes formed by the reinforcing plate 2. The opening portion 7 is provided, and an exposed portion 8 of the reinforcing plate 2 is formed around the opening portion 7.

As illustrated in a top view of Fig. 2, a metal wiring pattern 1 b is formed on the film substrate 1 a in the flexible wiring board 1 and is arranged such that the solid state imaging element board 10 is electrically connected to the metal wiring pattern 1 b. On the flexible wiring board 1, chip components 11 and a connector 12 are provided so as to be connected to the metal wiring pattern 1b. Ground portions of the metal wiring pattern 1 b are electrically connected to the reinforcing plate 2 of the SUS plate. In this case, the solid state imaging element board 10 uses a board in which the rear surface thereof is coated with a black epoxy resin film (not shown) serving as a light-shielding film. The light-shielding film may be a metal film, such as a tungsten thin film, formed over the rear surface of the solid state imaging element board 10.

According to the configuration, by merely forming strip-shaped uneven shape in the resin mold, it is possible to significantly enhance heat dissipation and properly maintain mechanical strength. In addition, while an advantage of a small thickness of the flexible board 1 is provided, it is possible to assure high strength yielded by the resin mold having uneven shape and the reinforcing plate 2 having the same outer shape as that of the resin mold. Further, the cut portion 3 and the positioning hole 5 serving as reference holes are used as references when the solid state imaging element board 10 is placed, and also used as references when the lens casing 6 is placed on the opposite side as shown in Fig. 3. Therefore, an optical axis of the solid state imaging element board 10 and an optical axis of the lens 15 can be aligned to each other with high precision. The exposed portion 4 of the reinforcing plate is provided, which can avoid obstacles to recognition of references, such as displacement of the flexible wiring board 1 and a projection from an end face. Accordingly, the shape of an end face of the SUS plate can be assured with high precision. Further, the exposed portion 8 of the reinforcing plate around the opening portion 7 also prevents occurrence of a shield to the imaging area of the solid state imaging element board 10, so that the imaging area can be assured with high accuracy. The chip components 11 are mounted on the surface of the flexible wiring board 1, which can enhance the degree of freedom of an electric wiring design. Specifically, the chip components 11 can be placed in the vicinity of the solid state imaging element, whereby an electric characteristic can be optimized. Further, the connector 12 is mounted on the flexible board 1, which can extract a signal from the solid state imaging element board 10 to an outside, whereby a connection with a portable device can be freely established. When the flexible wiring board 1 larger than the reinforcing plate 2 is used as a flexible wiring as it is, the strength at a step between the flexible wiring board 1 and the reinforcing plate 2 may be insufficient. In this case, in place of the connector 12, another flexible wiring board may be connected directly. Since the metal wiring pattern 1 b is electrically connected to the reinforcing plate 2 of the SUS plate, noise can be reduced and static electricity can be shielded, whereby a stable electrical characteristic can be obtained. Moreover, the rear surface of the solid state imaging element board 10 is coated with a light shielding film made from a metal thin film such as tungsten, it is possible to eliminate noise of an imaging signal caused by light incident on the rear surface of the solid state imaging element board 10.

Fig. 3 is an exploded oblique perspective view of the solid state imaging device of the first embodiment acquired when the solid state imaging device in Fig. 1 is viewed from its back side.
The flexible wiring board 1 and the reinforcing plate 2 having an outer shape identical in size with that of the flexible wiring board 1 are integrally stacked. The cut portion 3 and the positioning hole 5 serving as reference holes are formed. The opening portion 7 is formed in the reinforcing plate 2, and the step portion 13 thinner than the general thickness of the reinforcing plate 2 is formed around the opening portion 7. The light-transmitting member 14 is fitted into the step portion 13 and is set in the reinforcing plate 2. As the light-transmitting member 14, glass exhibiting an infrared radiation cut-off filter function is used. A reference projecting portion 17 is formed on a lens casing 16 integrated with the optical lens 15. The illustrated reference projecting portion 17 fits into the positioning hole 5 serving as a reference hole. A projection serving as a reference to be fitted into the cut portion 3 is similarly formed but unillustrated.

According to the configuration, it is possible to eliminate positional displacement of the light-transmitting member 14 and bond the light-transmitting member 14 to the step portion 13 so as to close the opening portion 7 while preventing spread of an adhesive for bonding purpose to an unnecessary area. The reference projecting portions 17 of the lens casing 16 are fitted to the positioning hole 5 serving as a reference hole and the cut portion 3 serving as a reference hole, which can be used as a common reference to the solid state imaging element board 10 on the opposite side. Therefore, high precision alignment of optical axes can be performed.

Fig. 4 is an oblique perspective view of the solid state imaging device of the first embodiment acquired when the imaging device is viewed from the same side where Fig. 1 is viewed.
The flexible wiring board 1 and the reinforcing plate 2 having outer shape identical in size with that of the flexible wiring board 1 are integrally laminated, and the cut portion 3 and the positioning hole 5 that serve as reference holes are formed. Further, the molding resin 18 is formed so as to cover the solid state imaging element board 10 and the chip component 11, and strip-shaped uneven shape is formed on a surface of the molding resin 18. A molding resin cut portion 19 is formed in the molding resin 18 so as to avoid the cut portion 3 serving as the reference hole. Further, a wiring cable 20 made of a flat cable is drawn from the connector 12.

In the configuration, the molding resin 18 having the strip-shaped uneven shape is formed on the rear surface of the solid state imaging element board 10, whereby a heat dissipation characteristic and the strength can be enhanced. The resin may have a light shielding characteristic, whereby noise caused transmitted light from the rear surface of the solid state imaging element board 10 can be reduced. Further, components such as the solid state imaging element board 10 and the chip components 11 can be prevented from dropping, and can firmly be bonded. In order to further block the transmitted light from the rear surface of the solid state imaging element board 10, the light shield film may also be formed on the rear surface of the solid state imaging element board 10, as mentioned previously. The molding resin 18 may be molded so as to define the molding resin cut portion 19, whereby intrusion of a shield into the cut portion 3 serving as a reference hole can be prevented. Further, molding is performed so as to avoid the connector 12, whereby the wiring cable 20 can be laid after mounting of the lens casing 16. When the wiring cable 20 is attached beforehand, molding may also be performed up to a top of the connector 12 and a top of the wiring cable 20 while avoiding the positioning hole 5 serving as a reference hole, thereby reinforcing a connection of the wiring cable.

Fig. 5 is an oblique perspective view of the solid state imaging device of the first embodiment acquired when the imaging device is viewed from the same side where Fig. 3 is viewed.
The lens casing 16 is mounted from above on the flexible wiring board 1 covered with the molding resin 18 and the reinforcing plate 2. The same reference as that used for setting the solid state imaging element board 10 is used, and hence optical axes can be aligned to each other with high precision.

As mentioned above, according to the solid state imaging device of the present invention, a molding resin is formed on the rear surface of the solid state imaging element, and an uneven shape can readily be formed on the resin mold by use of a stamper having an uneven shape. As a result, an area contacting the atmosphere becomes increased, so that more efficient heat dissipation and cost reduction can be obtained.

Figs. 6(a) and 6(b) are views showing a result of dissipation effect resultant from simulation of a thermal fluid. As shown in Figs. 6(a) and 6(b), a rear side of the solid state imaging element mounted to the flexible wiring board having the opening portion 7 through a flip-chip mounting process is molded with a resin. An uneven shape is formed on a surface of the resin mold. It is preferable that the uneven shaped is formed such that the surface area of the uneven shape is twice or more that of a surface of a resin mold which does not have any uneven shape.

Fig. 6(a) is a view showing heat generated when the mold does not have any uneven shape, whilst Fig. 6(b) shows a heating result yielded when the resin mold is imparted with an uneven shape. By forming the concave-convex shape on the surface of the mold being, an increase in the temperature of the solid state imaging element can be reduced by about 10%.
According to the structure, it is possible to efficiently radiate heat from the solid state imaging device. Hence, the solid state imaging device is hardly raised to high temperature and hardly cause error operation. Further, since heat dissipation is obtained by a simple structure, the solid state imaging device can be slimmed down easily, and can have high rigidity.

### (Second Embodiment)

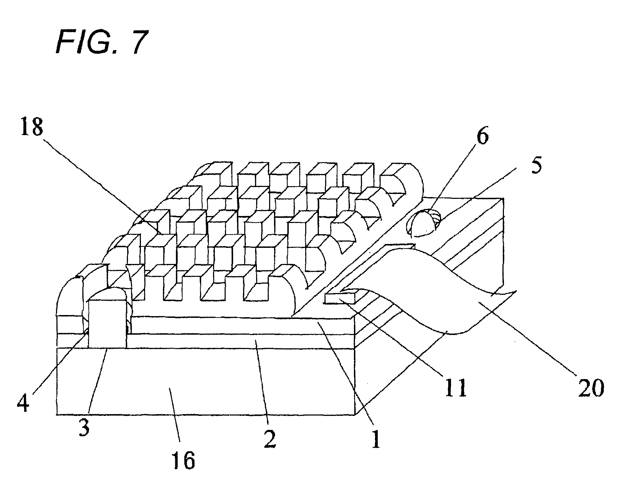

Fig. 7 is an assembling drawing of a solid state imaging device of a second embodiment of the present invention.
A difference between the present embodiment and the first embodiment lies in that the molding resin 18 has a different shape. In the first embodiment, the molding resin 18 has the uneven shape having a transverse line pattern. In the second embodiment, the molding resin has an uneven shape having lattice pattern. The lattice-patterned uneven shape can further increase the heat radiating area, to thus enhance the heat dissipation effect.
In the first embodiment, the uneven shape is formed by the stamper. However, in the second embodiment, the uneven shape of the molding resin 18 is resin-molded by injection molding using a metal mold having a lattice-shaped uneven shape because the structure of the second embodiment is complicated.

In the molding resin 18 of the second embodiment, the resin contains a metal filler, and a material exhibiting high thermal conductivity is used. Therefore, heat radiation efficiency can further be enhanced.
According to the structure, efficient dissipation of heat from the solid state imaging device can be obtained. Hence, the solid state imaging device is hardly raised to high temperature, to thus cause error. Further, since heat dissipation is performed by a simple structure, the solid state imaging device can be easily slimmed down, and can have high rigidity.

The uneven shape of the resin mold is not limited to the first and second embodiments. The pattern can be changed, as required, so long as the pattern enables prevention of a reduction in mechanical strength and enhancement of high dissipation.
In the embodiment, injection molding is used for forming a resin mold. However, the resin mold may also be formed by a hot melting technique through use of a metal mold having a similar uneven shape. Under a method for manufacturing a resin mold one by one by means of the hot melting technique, a facility is simplified, and the resin mold can be manufactured within a short period of time, so that a manufacturing cost can be reduced.
The present patent application is based on Japanese Patent Application filed on February 6, 2008 (Application No. 2008-026278), and the entire subject matter of which is incorporated herein by reference.

### Industrial Applicability

The solid state imaging device and the manufacturing method thereof according to the present invention can slim down of the solid state imaging device and are useful as a solid state imaging device and a manufacturing method thereof capable of easy achieving high rigidity, enhanced precision, and high reliability.

## Claims

1. A solid state imaging device comprising:
a substrate having an opening portion;
a solid state imaging element mounted to the substrate through a flip-chip process; and
a resin mold portion formed on a rear surface of the solid state imaging element,
wherein the resin mold portion has a surface of an uneven shape.

2. The solid state imaging device according to claim 1,
wherein the resin mold portion includes: a portion where a distance between an outer surface and the solid state imaging element is large; and a portion where the distance is small, thereby having a radiator fin function.

3. The solid state imaging device according to claim 1 or 2,
wherein the uneven shape includes a strip pattern.

4. The solid state imaging device according to claim 1 or 2,
wherein the uneven shape defines a plurality of pillar-shaped projections.

5. The solid state imaging device according to claim 1 or 2,
wherein the uneven shape includes a lattice pattern.

6. The solid state imaging device according to any one of claims 1 to 5, comprising:
a multilayer board including a flexible wiring board having the opening portion and a reinforcing plate integrally stacked on the flexible wiring board;
a light-transmitting member placed on a reinforcing plate side of the multilayer board so as to close the opening portion; and
a solid state imaging element board placed on a flexible wiring board side of the multilayer board,
wherein the reinforcing plate has a reference hole used for setting the solid state imaging element board, and
wherein the reinforcing plate is exposed from the flexible wiring board around a peripheral edge of the reference hole, and the solid state imaging element board and the light-transmitting member are placed on both sides of the multilayer board while the reference hole is taken as a common reference.

7. The solid state imaging device according to claim 6,
wherein the light-transmitting member and an optical lens are attached to the reinforcing plate, and
wherein the optical lens and the solid state imaging element board are positioned while the reference hole is taken as a common reference from both front side and back side thereof.

8. The solid state imaging device according to claim 6 or 7,
wherein the light-transmitting member is an optical filter.

9. The solid state imaging device according to any one of claims 6 to 8,
wherein the reinforcing plate is a metal plate.

10. The solid state imaging device according to claim 9,
wherein a ground portion of a wiring pattern of the flexible wiring board is electrically connected to the reinforcing plate.

11. The solid state imaging device according to any one of claims 6 to 10,
wherein a periphery of the opening portion of the reinforcing plate where the light-transmitting member is to be placed is smaller in thickness than a surrounding of the opening portion, thereby forming a thin-wall portion

12. The solid state imaging device according to any one of claims 6 to 11,
wherein a connector is mounted on a wiring pattern of the flexible wiring board.

13. The solid state imaging device according to any one of claims 8 to 12,
wherein a chip component is mounted on a wiring pattern of the flexible wiring board.

14. The solid state imaging device according to any one of claims 1 to 13,
wherein the resin mold is made of a high thermal conductive material.

15. A method for manufacturing the solid state imaging device according to any one of claims 1 to 14, said method comprising:
a step of mounting the solid state imaging element on the flexible wiring board having the opening portion though the flip-chip mounting process;
a step of filling the rear surface of the solid state imaging element with molding resin; and
a step of forming the uneven shape through a transfer using a stamper having a predetermined uneven shape after the step of filling, and hardening the resin.

16. A method for manufacturing the solid state imaging device according to any one of claims 1 to 14, said method comprising:
a step of mounting the solid state imaging element on the flexible wiring board having the opening portion through the flip-chip mounting process; and
a step of forming a resin sealed portion by injection molding using a metal mold having an uneven shape.

17. A method for manufacturing the solid state imaging device according to any one of claims 1 to 14, said method comprising:
a step of mounting the solid state imaging element on the flexible wiring board having the opening portion through the flip-chip mounting process; and
a step of forming a resin sealed portion by a hot melting technique using a metal molding having an uneven shape.
